# EUROPEAN PATENT APPLICATION

(11) **EP 4 742 530 A1**
(43) Date of publication of application: **13.05.2026**
(21) Application number: 25212877.2
(22) Date of filing: 02.11.2025
(51) Int. Cl.: H03F 1/22, H03F 3/193, H03F 3/24, H03F 3/72

(54) **AMPLIFIER AND OPERATION METHOD THEREOF**

(30) Priority: 11.11.2024 TW 113143128
(71) Applicant: RichWave Technology Corp., Taipei City 114 (TW)
(72) Inventor: Peng, Tien-Yun, 114 Taipei City (TW); Chen, Chih-Sheng, 114 Taipei City (TW)
(74) Representative: Straus, Alexander

(57) **Abstract**

An amplifier (100) includes a signal input terminal (NIN), a signal output terminal (NOUT), an amplification circuit (101), and at least one variable voltage generation circuit (110). The signal input terminal (NIN) may receive an input signal (SIN). The signal output terminal (NOUT) may output an amplified signal (SOUT). A transistor (T1) of the amplification circuit (101) includes a first terminal, a second terminal, a control terminal, and a body terminal, where the control terminal is coupled to the signal input terminal (NIN), the second terminal is coupled to the signal output terminal (NOUT), and the body terminal is floating. The variable voltage generation circuit (110) is coupled to the transistor (T1). During a transition period, a first voltage difference presents between the second and first terminals of the transistor (T1), and during a steady period, a second voltage difference smaller than the first voltage difference presents.

## Description

### Field of the Invention

The disclosure relates to an amplifier and its operation method, and more particularly, to an amplifier that may quickly transition from a transient state to a steady state and its operation method.

### Background of the Invention

Amplifiers are crucial components of radio-frequency (RF) transceiver circuits, used for amplifying RF signals. For example, amplifiers may include power amplifiers (PA) and low noise amplifiers (LNA). In a communication system, amplifiers may be disposed near an antenna and used to amplify a received signal. The performance of an amplifier may be evaluated by various parameters, such as gain, noise figure, linearity, power consumption, and stability.

In amplifiers, to achieve a good noise figure, floating body transistors, where the body terminal is floating, may be used. In practical applications, amplifiers may be switched between various operating states. During these transitions, the threshold voltage of the floating body transistor may be less stable, causing the transistor's current (e.g., drain-source current) to stabilize slower, resulting in slower transition response of the amplifier. Observations indicate that increasing the voltage difference between the drain and source of the transistor may help the transistor stabilize quickly, thus stabilizing the drain-source current faster and improving the transition response of the amplifier. Therefore, there is a need for an amplifier that may be switched quickly between different operating modes while maintaining desirable performance parameters such as noise figure.

### Summary of the Invention

The present invention is set out in the appended set of claims.

### Brief Description of the Drawings

In the following, the invention is further illustrated by way of example, taking reference to the accompanying drawings. Thereof:
FIG.1 schematically shows an amplifier according to one embodiment of the disclosure;
FIG.2 schematically shows an amplifier according to another embodiment of the disclosure;
FIG.3 and FIG.4 schematically show waveform diagrams of voltage levels at some nodes of an amplifier according to an embodiment of the disclosure;
FIG.5 schematically shows an amplifier according to another embodiment of the disclosure;
FIG.6 schematically shows an amplifier according to another embodiment of the disclosure;
FIG.7 schematically shows a waveform diagram of voltage levels at some nodes of an amplifier according to one embodiment of the disclosure;
FIG.8 schematically shows an amplifier according to another embodiment of the disclosure;
FIG.9 schematically shows an amplifier according to another embodiment of the disclosure;
FIG.10 schematically shows a waveform diagram of voltage levels at some nodes of an amplifier according to an embodiment of the disclosure; and
FIG.11 schematically shows a flowchart of an amplifier operation method according to an embodiment of the disclosure.

### Detailed Description

Below, exemplary embodiments will be described in detail with reference to accompanying drawings so as to be easily realized by a person having ordinary knowledge in the art. The inventive concept may be embodied in various forms without being limited to the exemplary embodiments set forth herein. Descriptions of well-known parts are omitted for clarity, and like reference numerals refer to like elements throughout.

By referring to the following detailed description and in conjunction with the accompanying drawings, the invention may be understood. It should be noted that, for the ease of understanding by the readers and for the simplicity of the drawings, only part of the electronic device is illustrated in the drawings of this invention, and the specific elements in the drawings are not drawn to scale. Moreover, the quantity and size of the elements in the drawings are merely illustrative and are not intended to limit the scope of the invention. In the drawings, elements marked with the same reference symbol have the same or similar attributes or functions in the context.

In the following specification and claims, terms such as "comprise," "include," and "have" are open terms, thus should be interpreted as "including but not limited to." Therefore, when the description of the present invention uses the terms "comprise," "include," and/or "have," they specify the presence of corresponding features, regions, steps, operations, and/or components, but do not exclude the presence of one or more corresponding features, regions, steps, operations, and/or components.

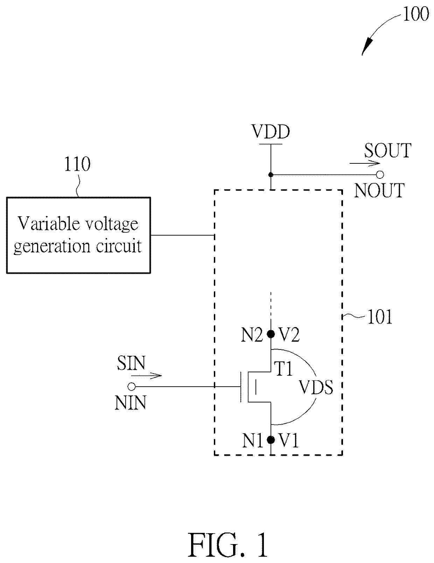

FIG.1 schematically shows an amplifier 100 according to an embodiment of the disclosure. As shown, the amplifier 100 includes a signal input terminal NIN, a signal output terminal NOUT, and an amplification circuit 101 coupled therebetween. For example, the signal input terminal NIN is coupled to a preceding circuit (e.g., an antenna) used to receive a signal SIN. The amplification circuit 101, for example, amplifies the signal SIN, and the signal output terminal NOUT is used to output an amplified signal SOUT to a subsequent circuit for further processing of the amplified signal.

In an embodiment, the amplification circuit 101 includes a first transistor T1. The first transistor T1 may include, for example, a Metal-Oxide-Semiconductor Field-Effect Transistor (MOSFET) or a Bipolar Junction Transistor (BJT). The first transistor T1 includes a first terminal, a second terminal, and a control terminal. For instance, in the case of an N-type MOSFET, the first terminal of the first transistor T1 is either a source or drain, the second terminal is the other, and the control terminal is a gate. Alternatively, in the case of a BJT, the first terminal of the first transistor T1 is either an emitter or collector, the second terminal is the other one of the emitter and collector, and the control terminal is a base. In some embodiments, the first terminal of the first transistor T1 is coupled to a first node N1, and the second terminal is coupled to a second node N2. Specifically, the first node N1 is further coupled to a reference voltage terminal, such as a ground, via other components (e.g., an inductor). The second node N2 is further coupled to an operation voltage terminal VDD, such as a system voltage terminal or battery voltage terminal, etc. Additionally, the second node N2 is further coupled to the signal output terminal NOUT. The control terminal of the first transistor T1 is coupled to the signal input terminal NIN to receive a radio frequency (RF) signal.

In some embodiments, the amplifier 100 further includes at least one variable voltage generation circuit 110, which is coupled to the amplification circuit 101, as further described below.

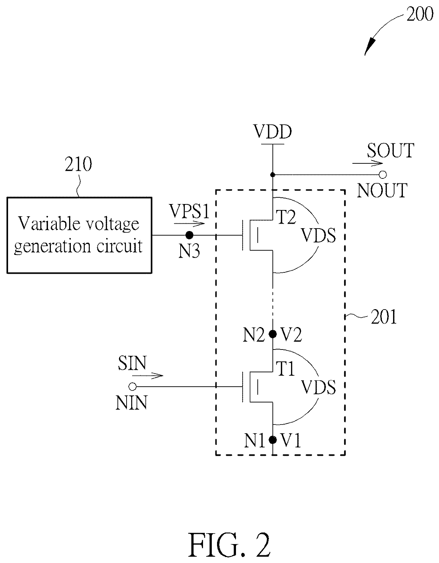

FIG.2 schematically shows an amplifier 200 according to another embodiment of the disclosure. The amplifier 200 may be similar to the amplifier 100 of FIG.1. Similarities may not be repeated, and only the main differences are described as follows. As shown, the amplification circuit 201 of the amplifier 200 may further include a second transistor T2.

In some embodiments, similar to the first transistor T1, the second transistor T2 may include a Metal-Oxide-Semiconductor Field-Effect Transistor (MOSFET), a Bipolar Junction Transistor (BJT), etc. The second transistor T2 may include a first terminal, a second terminal, and a control terminal. For example, the second transistor T2 may be an N-type MOSFET, with the source as the first terminal, the drain as the second terminal, and the gate as the control terminal. Alternatively, the second transistor T2 may be a P-type MOSFET, with the drain as the first terminal, the source as the second terminal, and the gate as the control terminal. These examples are illustrative and do not limit the disclosure. In other embodiments, the first transistor T1 and/or the second transistor T2 may be other suitable types of transistors and may be coupled in other suitable ways.

As shown, the first terminal of the second transistor T2 may be coupled to the second node N2, the second terminal may be coupled to the signal output terminal NOUT, and the control terminal may be coupled to the third node N3. In other words, the first transistor T1 and the second transistor T2 may be cascode-connected. Furthermore, the first transistor T1 and the second transistor T2 may be directly cascode-connected or indirectly cascode-connected. For example, in the case of a direct cascode-connection, the first terminal of the second transistor T2 may be directly coupled to the second terminal of the first transistor T1, with no other active or passive components in between. Additionally, in the case of an indirect cascode-connection, additional components, such as a third transistor (not shown), may be placed between the first terminal of the second transistor T2 and the second terminal of the first transistor T1.

In some embodiments, the first transistor T1 and/or the second transistor T2 may be fabricated using processes such as silicon-on-insulator (SOI) or GaAs-related processes. For example, in the manufacturing process of IC (integrated circuit) devices, transistors may be formed on a substrate. Each unit in the transistors may include, for example, a gate electrode. A gate dielectric may be disposed between the gate electrode and the substrate. Furthermore, for example, the manufacturing process may include, but are not limited to, implantation, wafer bonding, grinding, ion splitting, etc.

In further embodiments, the first transistor T1 and/or the second transistor T2 may each include a body terminal (a.k.a. bulk terminal), which is floating or contacted. For instance, a floating body terminal indicates that the body terminal does not have a predetermined voltage, which is advantageous to achieve a more desirable noise figure (NF). However, since the body terminal does not have a definite voltage level, the threshold voltage of the transistor is less stable, leading to slower current stabilization of the transistor, and resulting in slower response of the amplification circuit. Furthermore, the body terminal of the first transistor T1 is preferably floating. Experiments show that, when switching between different operation states, providing a larger voltage difference (VDS) between the second terminal and the first terminal of the first transistor T1 may accelerate the stabilization of the threshold voltage of the first transistor T1, which allows the current to stabilize more quickly, achieving a quick transition response. A quick transition response is conducive to achieving a good noise figure for the amplifier. In some embodiments, after the first transistor T1 reaches a steady state, a normal or lower voltage difference VDS may be provided between the second terminal and the first terminal of the first transistor T1 for a normal operation or a power-saving operation of the circuit. In some embodiments, a contacted body may indicate that the body terminal has a predetermined voltage. The body terminal of the second transistor T2 is preferably floating or contacted.

As shown in FIG.2, a voltage difference may present between the second terminal and the first terminal of the first transistor T1, hereinafter referred to as VDS(T1). For the first transistor T1, the first terminal is coupled to the first node N1, and the second terminal is coupled to the second node N2. Therefore, the voltage difference VDS(T1) between the second terminal and the first terminal of the first transistor T1 may be substantially determined by the difference between the voltage level V2 at the second node N2 and the voltage level V1 at the first node N1. This may be expressed as VDS=V2-V1. For example, in the case of the first transistor T1 being an N-type MOSFET, the voltage difference VDS may be the voltage difference between the drain and the source, i.e. the drain-source voltage.

In some embodiments, when switching between different operation states, a transition period PT, where the current flowing through the first transistor T1 (e.g., drain-source current) may be substantially unstable, may present. Following the transition period PT, a steady period PS, where the current flowing through the first transistor T1 may be substantially stable, may be reached. For example, during the steady period PS, the variation in the current flowing through the first transistor T1 is less than ±10%. Generally, the transition period PT may correspond to a short transient state when the amplifier is powered on. In some embodiments, the duration of the transition period PT may be substantially between 360 nanoseconds and 440 nanoseconds.

In some embodiments, the first variable voltage generation circuit 210 may be coupled to the third node N3, thereby being coupled to the control terminal of the second transistor T2. The first variable voltage generation circuit 210 may be used to provide a pulse voltage signal VPS1 at the third node N3, which may have a variable voltage level. The voltage level of the pulse voltage signal VPS1 may be configured to determine the voltage level at the control terminal of the second transistor T2, and thus to determine the voltage level at the first terminal of the second transistor T2. In the embodiment shown in FIG.2, the second terminal of the first transistor T1 may be coupled to the first terminal of the second transistor T2 via the second node N2. Therefore, the voltage level at the second terminal of the first transistor T1 may be determined by the voltage level of the pulse voltage signal VPS1. Specifically, during the transition period PT, the pulse voltage signal VPS1 may have a first voltage level L1, and the voltage level at the second terminal of the first transistor T1 may be determined by the first voltage level L1. During the steady period PS following the transition period PT, the pulse voltage signal VPS1 may have a second voltage level L2, and the voltage level at the second terminal of the first transistor T1 may be determined by the second voltage level L2. For example, the first voltage level L1 may be different from the second voltage level L2.

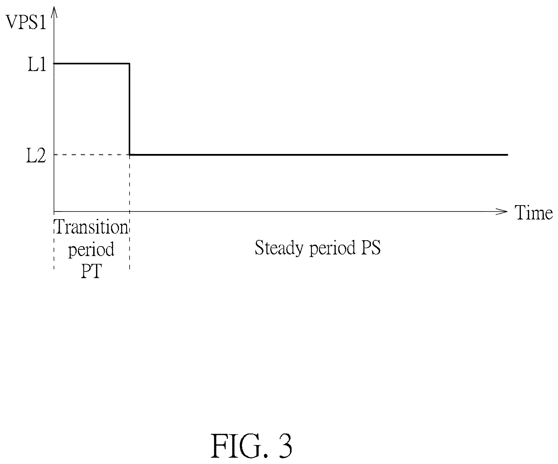

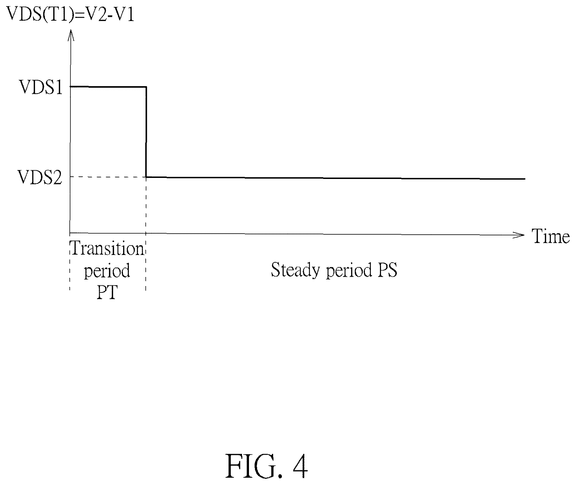

FIG.3 and FIG.4 schematically show waveform diagrams of the voltage levels of some nodes of the amplifier according to an embodiment of the disclosure. FIG.3 schematically shows a waveform diagram of the pulse voltage signal VPS1 during the transition period PT and the steady period PS. FIG.4 schematically shows a waveform diagram of the voltage difference VDS(T1) between the second terminal and the first terminal of the first transistor T1 during the transition period PT and the steady period PS. In some embodiments, at the first node N1, the voltage levels during the transition period PT and the steady period PS may be substantially the same (e.g., remain unchanged). For example, it may be a ground voltage. Therefore, the voltage level at the first terminal of the first transistor T1 may substantially remain the same. In some embodiments, the first voltage level L1 may be higher than the second voltage level L2.

As shown in FIG.3, during the transition period PT, the pulse voltage signal VPS1 has a higher first voltage level L1, which pulls up the voltage level at the second terminal of the first transistor T1, thereby providing a larger voltage difference, such as a first voltage difference VDS1, between the second terminal and the first terminal of the first transistor T1. During the steady period PS following the transition period PT, the pulse voltage signal VPS1 has a lower second voltage level L2, which pulls back the voltage level at the second terminal of the first transistor T1 back to a normal or lower level, thereby providing a normal or smaller voltage difference, such as a second voltage difference VDS2, between the second terminal and the first terminal of the first transistor T1. As shown in FIG.4, during the transition period PT, the voltage difference VDS(T1) between the second terminal and the first terminal of the first transistor T1 may be the first voltage difference VDS1, and during the steady period PS, it may be the second voltage difference VDS2. Furthermore, the first voltage difference VDS1 is greater than the second voltage difference VDS2. For example, the first voltage difference VDS1 may be 1.0 volts, and the second voltage difference VDS2 may be 0.6 volts.

In the aforementioned embodiment, during the transition period PT, the larger voltage difference VDS1, for example, 1.0 volt, may present between the second terminal and the first terminal of the first transistor T1. Therefore, the threshold voltage of the first transistor T1 may stabilize more quickly, allowing a current (e.g., drain-source current) of the first transistor T1 to stabilize more quickly, thereby accelerating the transition response of the amplifiers 100 and 200. During the steady period PS, the normal or lower voltage difference VDS2, for example, 0.6 volts, may present between the second terminal and the first terminal of the first transistor T1. Therefore, the first transistor T1 may operate in a normal mode or a power-saving mode.

In some embodiments, the second terminal of the second transistor T2 may be coupled to the operation voltage terminal VDD. A voltage difference, referred to as VDS(T2), may exist between the second terminal and the first terminal of the second transistor T2. The voltage difference VDS(T2) between the second terminal and the first terminal of the second transistor T2 may be substantially determined by the difference between the operation voltage terminal VDD and the voltage level V2 at the second node N2. During the transition period PT, in response to the pulse voltage signal VPS1 with a higher voltage level L1, the operation voltage terminal VDD may provide a first operation voltage. During the steady period PS following the transition period PT, in response to the pulse voltage signal VPS1 with a normal or lower voltage level L2, the operation voltage terminal VDD may provide a second operation voltage, and the first operation voltage may be higher than the second operation voltage.

Furthermore, during the transition period PT, the voltage difference VDS1(T1) between the second terminal and the first terminal of the first transistor T1 may be larger (for example, the larger first voltage difference VDS1). In this case, a higher first operation voltage may ensure that the voltage difference VDS(T2) between the second terminal and the first terminal of the second transistor T2 remains at an appropriate level, for example, not decreased by the larger first voltage difference VDS1. In a specific embodiment, the voltage difference VDS(T2) between the second terminal and the first terminal of the second transistor T2 may remain substantially the same during both the transition period PT and the steady period PS, allowing the amplifier to operate normally during both periods.

In the aforementioned embodiment, the waveform diagram of the pulse voltage signal VPS1 is merely an illustrative example, and may be adjusted based on the needs and characteristics of the components. For instance, in other embodiments, the pulse voltage signal VPS1 may exhibit other waveform changes. For example, in the case where the second transistor T2 is a P-type transistor, the first voltage level L1 may be lower than the second voltage level L2.

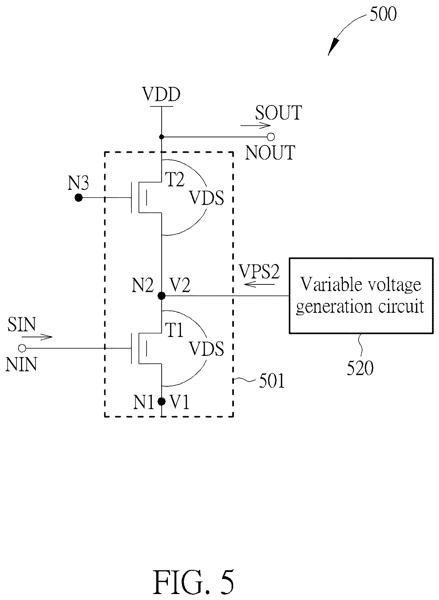

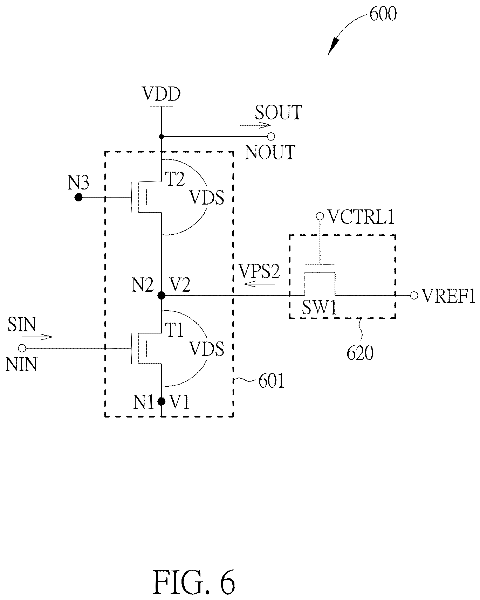

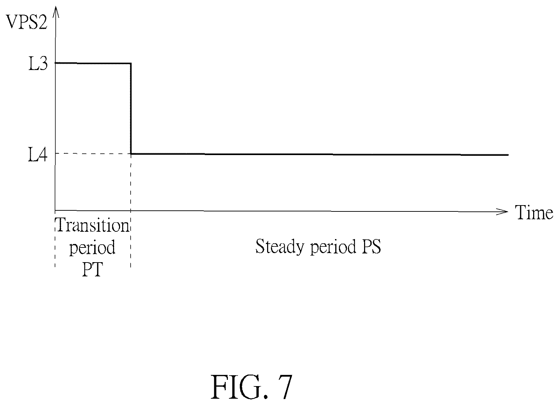

FIG.5 schematically shows an amplifier 500 according to another embodiment of the disclosure. FIG.6 schematically shows an amplifier 600 according to another embodiment of the disclosure and further shows the internal structure of the variable voltage generation circuit 620. FIG.7 schematically shows the voltage levels of some nodes of the amplifier according to an embodiment of the disclosure, where a waveform diagram of the pulse voltage signal VPS2 during the transition period PT and the steady period PS is shown.

As shown in FIG.5, the amplifier 500 may include an amplification circuit 501, which may be similar to the amplification circuit 201 in FIG.2. Similarities may not be repeated, and only the main differences are described as follows. The amplifier 500 may include a second variable voltage generation circuit 520, which may be an embodiment of the variable voltage generation circuit 110 in FIG.1. The second variable voltage generation circuit 520 may be coupled to the second node N2, thereby further being coupled to the second terminal of the first transistor T1. The second variable voltage generation circuit 520 may provide a pulse voltage signal VPS2 at the second node N2, and the pulse voltage signal VPS2 may have a variable voltage level. The voltage level of the pulse voltage signal VPS2 may be configured to determine the voltage level at the second node N2, thereby determining the voltage level at the second terminal of the first transistor T1. In some embodiments, referring to FIG.7, during the transition period PT, the pulse voltage signal VPS2 may have a third voltage level L3, and the voltage level at the second terminal of the first transistor T1 may be determined by the third voltage level L3. During the steady period PS following the transition period PT, the pulse voltage signal VPS2 may have a fourth voltage level L4, and the voltage level at the second terminal of the first transistor T1 may be determined by the fourth voltage level L4.

As shown in FIG.6, the amplifier 600 may include an amplification circuit 601 and a variable voltage generation circuit 620. The variable voltage generation circuit 620 may be an embodiment of the second variable voltage generation circuit 520. The variable voltage generation circuit 620 may include a switch SW1. The switch SW1 may include a first terminal, a second terminal, and a control terminal. The first terminal of the switch SW1 may be coupled to a reference voltage terminal to receive a first reference voltage VREF1. The second terminal of the switch SW1 may be coupled to the second node N2. The control terminal of the switch SW1 may be used to receive a control signal VCTRL1.

As shown in FIG.7, regarding the voltage level of the pulse voltage signal VPS2, the third voltage level L3 during the transition period PT may be different from the fourth voltage level L4 during the steady period PS. In a specific embodiment, the third voltage level L3 may be higher than the fourth voltage level L4. Therefore, during the transition period PT, the first voltage difference VDS1 between the second terminal and the first terminal of the first transistor T1 may be greater than the second voltage difference VDS2 during the steady period PS. During the transition period PT, the switch SW1 may be turned on according to the control signal VCTRL1, such that the first reference voltage VREF1 is received at the second node N2. In this case, the voltage level of the first reference voltage VREF1 may correspond to the third voltage level L3. During the steady period PS, the switch SW1 may be turned off according to the control signal VCTRL1, such that the first reference voltage VREF1 is not received at the second node N2. In this case, the voltage level at the second node N2 may correspond to the fourth voltage level L4.

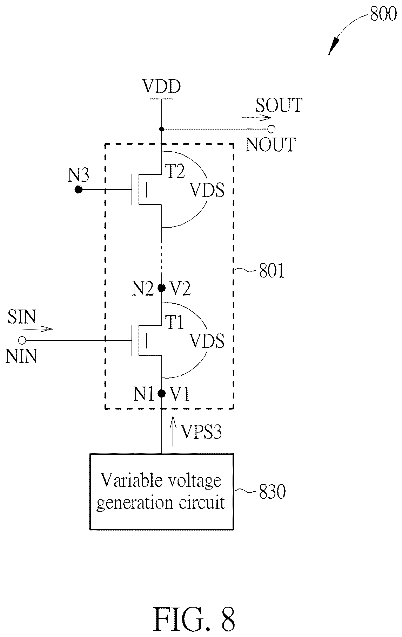

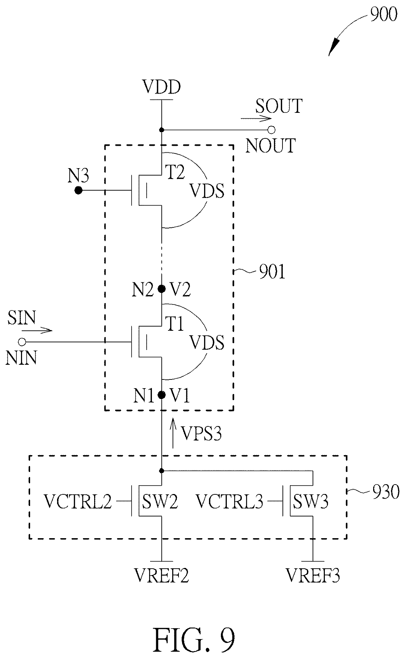

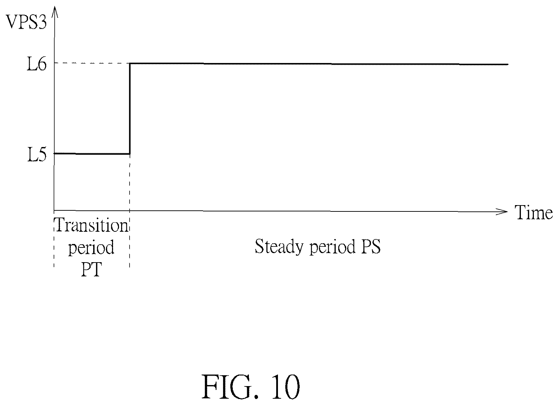

FIG.8 schematically shows an amplifier 800 according to another embodiment of the disclosure. FIG.9 schematically shows an amplifier 900 according to another embodiment of the disclosure and further illustrates the internal structure of the variable voltage generation circuit 930. FIG.10 schematically shows the voltage levels of some nodes of the amplifier according to an embodiment of the disclosure, where a waveform diagram of the pulse voltage signal VPS3 during the transition period PT and the steady period PS is shown.

As shown in FIG.8, the amplifier 800 may include an amplification circuit 801, which may be similar to the amplification circuit 201 in FIG.2. Similarities may not be repeated, and only the main differences are described as follows. The amplifier 800 may include a third variable voltage generation circuit 830, which may be an embodiment of the variable voltage generation circuit 110 in FIG.1. The third variable voltage generation circuit 830 may be coupled to the first node N1, thereby further being coupled to the first terminal of the first transistor T1. The third variable voltage generation circuit 830 may provide a pulse voltage signal VPS3 at the first node N1, which may have a variable voltage level. The voltage level of the pulse voltage signal VPS3 may be configured to determine the voltage level at the first node N1, thereby determining the voltage level at the first terminal of the first transistor T1. In some embodiments, referring to FIG.10, during the transition period PT, the pulse voltage signal VPS3 may have a fifth voltage level L5, and the voltage level at the first terminal of the first transistor T1 may be determined by the fifth voltage level L5. During the steady period PS following the transition period PT, the pulse voltage signal VPS3 may have a sixth voltage level L6, and the voltage level at the first terminal of the first transistor T1 may be determined by the sixth voltage level L6.

As shown in FIG.9, the amplifier 900 may include an amplification circuit 901 and a variable voltage generation circuit 930. The variable voltage generation circuit 930 may be an embodiment of the variable voltage generation circuit 830. The variable voltage generation circuit 930 may include switches SW2 and SW3. The switch SW2 may include a first terminal, a second terminal, and a control terminal. The first terminal of the switch SW2 may be coupled to a reference voltage terminal to receive a second reference voltage VREF2. The second terminal of the switch SW2 may be coupled to the first node N1. The control terminal of the switch SW2 may be used to receive a control signal VCTRL2. Similarly, the switch SW3 may include a first terminal, a second terminal, and a control terminal. The first terminal of the switch SW3 may be coupled to a reference voltage terminal to receive a third reference voltage VREF3. The second terminal of the switch SW3 may be coupled to the first node N1. The control terminal of the switch SW3 may be used to receive a control signal VCTRL3. In some embodiments, the voltage levels of the second reference voltage VREF2 and the third reference voltage VREF3 may be different or the same. For example, the second reference voltage VREF2 may be a negative voltage level, and the third reference voltage VREF3 may be a zero voltage level.

As shown in FIG.10, regarding the voltage level of the pulse voltage signal VPS3, the fifth voltage level L5 during the transition period PT may be different from the sixth voltage level L6 during the steady period PS. In a specific embodiment, the fifth voltage level L5 may be lower than the sixth voltage level L6. Furthermore, during the transition period PT, the switch SW2 may be turned on according to the control signal VCTRL2, and the switch SW3 may be turned off according to the control signal VCTRL3, such that the second reference voltage VREF2 is received at the first node N1. In this case, the voltage level of the second reference voltage VREF2 may correspond to the fifth voltage level L5, for example, a negative voltage level. During the steady period PS, the switch SW2 may be turned off according to the control signal VCTRL2, and the switch SW3 may be turned on according to the control signal VCTRL3, such that the third reference voltage VREF3 is received at the first node N1. In this case, the voltage level of the third reference voltage VREF3 may correspond to the sixth voltage level L6, for example, a zero voltage level.

In this embodiment, the voltage level at the second node N1 may be substantially the same (e.g., remain unchanged) during both the transition period PT and the steady period PS. Therefore, the voltage level at the second terminal of the first transistor T1 may also remain substantially the same. Since the voltage level at the first node N1 may be lower during the transition period PT (compared to the voltage level during the steady period PS), the voltage level at the first terminal of the first transistor T1 may be lower during the transition period PT. Consequently, the first voltage difference VDS1 between the second terminal and the first terminal of the first transistor T1 during the transition period PT may be larger compared to the second voltage difference VDS2 during the steady period PS.

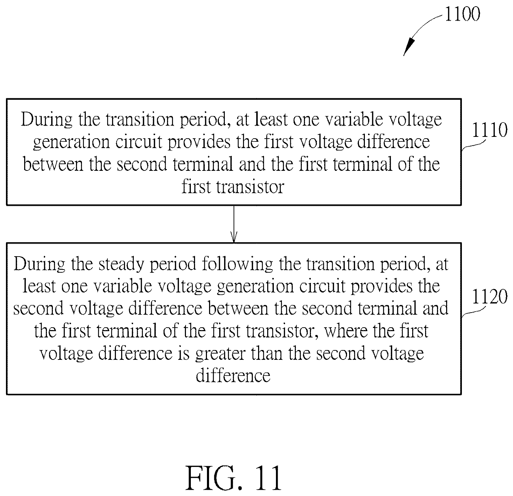

FIG.11 schematically shows a flowchart of an amplifier operation method 1100 according to an embodiment of the disclosure. The amplifier operation method 1100 is used to operate at least one of the aforementioned amplifiers. For example, the amplifier operation method 1100 includes the following steps.

Step 1110: During the transition period PT, at least one variable voltage generation circuit provides the first voltage difference VDS1 between the second terminal and the first terminal of the first transistor T1; and

Step 1120: During the steady period PS following the transition period PT, at least one variable voltage generation circuit provides the second voltage difference VDS2 between the second terminal and the first terminal of the first transistor T1, where the first voltage difference VDS1 is greater than the second voltage difference VDS2.

In some embodiments, at least one variable voltage generation circuit may be coupled to at least a node of the amplification circuit, and the node may be directly or indirectly coupled to the transistor of the amplification circuit. For example, a variable voltage generation circuit may provide a pulse voltage signal at the node. During different states of the transistor (e.g., a transition period, or a steady period), the pulse voltage signal may have different voltage levels, causing the voltage difference between the two terminals of the transistor (e.g., between the second terminal and the first terminal) to vary. For instance, the voltage difference between the two terminals of the transistor may be larger during the transition period, and may be normal or smaller during the steady period.

In summary, during the transition period PT, the voltage difference VDS1 between the second terminal and the first terminal (e.g., drain terminal and source terminal) of the transistor may be larger. Thus, the threshold voltage of the transistor may stabilize quickly, allowing the current of the transistor to stabilize quickly as well, accelerating the transition response of the amplifier. During the steady period PS following the transition period PT, the voltage difference between the second terminal and the first terminal of the transistor may be normal or lower, enabling the transistor to operate in a normal mode or a power-saving mode.

In the abovementioned at least one embodiment, for example, the voltage levels of the operation voltage terminal, at least one reference voltage terminal, and at least one pulse voltage signal (e.g., the pulse voltage signal VPS1, VPS2, or VPS3) may be set according to requirements and semiconductor processes. It should be noted that, regarding the cited embodiments, without departing from the spirit of the disclosure, features of different embodiments may be interchanged, reorganized, and mixed to accomplish other embodiments. As long as the features of different embodiments do not violate the spirit of the disclosure or conflict with each other, they may be used individually or in combination to be still fall within the scope of the disclosure. For example, according to one embodiment, at least two of the first variable voltage generation circuit, the second variable voltage generation circuit, and the third variable voltage generation circuit described herein may be used in combination.

In at least one embodiment of the disclosure, when an element is described to be coupled to another element, it may be directly coupled, or it may be indirectly coupled through another element. A reference voltage terminal described herein may provide a substantially stable reference voltage. The reference voltage terminal described herein may be, but is not limited to, a ground terminal. The multiple reference voltage terminals described herein may be the same or different reference voltage terminals. Switches described herein may be turned on or turned off. When a switch is turned on, a signal may pass through the switch, and when the switch is turned off, the signal may be blocked by the switch. Signals described herein may be current signals and/or voltage signals. Switches described herein may be made using transistors or other suitable electronic components. For example, when a switch includes a field-effect transistor, the first terminal of the switch may be one of a drain terminal or a source terminal, the second terminal of the switch may be the other of the drain terminal or the source terminal, and the switch may be controlled via the gate terminal. For example, when a switch includes a bipolar transistor, the first terminal of the switch may be one of a collector terminal or an emitter terminal, the second terminal of the switch may be the other of the collector terminal or the emitter terminal, and the switch may be controlled via the base terminal. In this document, when an element is described to be optionally provided or optionally set, it means that the element may be provided or not provided based on demand, and it still falls within the scope of the embodiment.

## Claims

1. An amplifier (100, 200, 500, 600, 800, 900), **characterised by** comprising:
a signal input terminal (NIN) configured to receive an input signal (SIN);
a signal output terminal (NOUT) configured to output an amplified signal (SOUT);
an amplification circuit (101, 201, 501, 601, 801, 901) coupled between the signal input terminal (NIN) and the signal output terminal (NOUT), the amplification circuit (101, 201, 501, 601, 801, 901) comprising a first transistor (T1), the first transistor (T1) comprising a first terminal, a second terminal, a control terminal and a body terminal, wherein the first terminal of the first transistor (T1) is coupled to a first node (N1), the second terminal of the first transistor (T1) is coupled to a second node (N2), the control terminal of the first transistor (T1) is coupled to the signal input terminal (NIN), and the body terminal of the first transistor (T1) is floating; and
at least one variable voltage generation circuit (110, 210, 520, 620, 830, 930) coupled to the amplification circuit (101, 201, 501, 601, 801, 901); wherein:
during a transition period (PT), the at least one variable voltage generation circuit (110, 210, 520, 620, 830, 930) provides a first voltage difference (VDS1) between the second terminal and the first terminal of the first transistor (T1); and
during a steady period (PS), the at least one variable voltage generation circuit (110, 210, 520, 620, 830, 930) provides a second voltage difference (VDS2) between the second terminal and the first terminal of the first transistor (T1); and
the first voltage difference (VDS1) is greater than the second voltage difference (VDS2).

2. The amplifier (200, 500, 600, 800, 900) of claim 1, **characterised in that**:
the amplification circuit (201, 501, 601, 801, 901) further comprises:
a second transistor (T2), comprising a first terminal, a second terminal, and a control terminal, wherein the first terminal of the second transistor (T2) is coupled to the second node (N2), the second terminal of the second transistor (T2) is coupled to the signal output terminal (NOUT), and the control terminal of the second transistor (T2) is coupled to a third node (N3).

3. The amplifier (200) of claim 2, **characterised in that**:
the at least one variable voltage generation circuit (110, 210, 520, 620, 830, 930) comprises a first variable voltage generation circuit (210) coupled to the third node (N3) and configured to provide a first pulse voltage signal (VPS1) at the third node (N3); during the transition period (PT), the first pulse voltage signal (VPS1) has a first voltage level (L1); and during the steady period (PS), the first pulse voltage signal (VPS1) has a second voltage level (L2);
or
the at least one variable voltage generation circuit (110, 210, 520, 620, 830, 930) comprises a second variable voltage generation circuit (520, 620) coupled to the second node (N2) and configured to provide a second pulse voltage signal (VPS2) at the second node (N2); during the transition period (PT), the second pulse voltage signal (VPS2) has a third voltage level (L3); and during the steady period (PS), the second pulse voltage signal (VPS2) has a fourth voltage level (L4);
or
the at least one variable voltage generation circuit (110, 210, 520, 620, 830, 930) comprises a third variable voltage generation circuit (830, 930) coupled to the first node (N1) and configured to provide a third pulse voltage signal (VPS3) at the first node (N1); during the transition period (PT), the third pulse voltage signal (VPS3) has a fifth voltage level (L5); and during the steady period (PS), the third pulse voltage signal (VPS3) has a sixth voltage level (L6).

4. The amplifier (200) of claim 3, **characterised in that**:
during the transition period (PT), a voltage level (V2) at the second terminal of the first transistor (T1) is determined by the first voltage level (L1) of the first pulse voltage signal (VPS1);
during the steady period (PS), the voltage level (V2) at the second terminal of the first transistor (T1) is determined by the second voltage level (L2) of the first pulse voltage signal (VPS1); and
during both the transition period (PT) and the steady period (PS), a voltage level (V1) at the first terminal of the first transistor (T1) remains substantially unchanged.

5. The amplifier (200) of claim 3, **characterised in that**:
the first voltage level (L1) is different from the second voltage level (L2).

6. The amplifier (200, 500, 600, 800, 900) of claim 2, **characterised in that** the second transistor (T2) further comprises a body terminal, and the body terminal of the second transistor (T2) is floating or contacted.

7. The amplifier (200, 500, 600, 800, 900) of claim 2, **characterised in that**:
the second terminal of the second transistor (T2) is further coupled to an operation voltage terminal (VDD);
during the transition period (PT), the operation voltage terminal (VDD) provides a first operation voltage;
during the steady period (PS), the operation voltage terminal (VDD) provides a second operation voltage; and
the first operation voltage is higher than the second operation voltage.

8. The amplifier (500, 600) of claim 3, **characterised in that**:
the third voltage level (L3) is higher than the fourth voltage level (L4).

9. The amplifier (600) of claim 3, **characterised in that**:
the second variable voltage generation circuit (620) comprises a first switch (SW1), and the first switch (SW1) comprises a first terminal, a second terminal, and a control terminal, wherein the first terminal of the first switch (SW1) is configured to receive a first reference voltage (VREF1), the second terminal of the first switch (SW1) is coupled to the second node (N2), and the control terminal of the first switch (SW1) is configured to receive a first control signal (VCTRL1); wherein:
during the transition period (PT), the first switch (SW1) is turned on according to the first control signal (VCTRL1) such that the first reference voltage (VREF1) is received at the second node (N2); and
during the steady period (PS), the first switch (SW1) is turned off according to the first control signal (VCTRL1).

10. The amplifier (800, 900) of claim 3, **characterised in that**:
the fifth voltage level (L5) is lower than the sixth voltage level (L6).

11. The amplifier (900) of claim 3, **characterised in that**:
the third variable voltage generation circuit (930) comprises a second switch (SW2), the second switch (SW2) comprises a first terminal, a second terminal, and a control terminal, wherein the first terminal of the second switch (SW2) is coupled to the first node (N1), the second terminal of the second switch (SW2) is coupled to a second reference voltage terminal (VREF2), and the control terminal of the second switch (SW2) is configured to receive a second control signal (VCTRL2);
the third variable voltage generation circuit (930) comprises a third switch (SW3), the third switch (SW3) comprises a first terminal, a second terminal, and a control terminal, wherein the first terminal of the third switch (SW3) is coupled to the first node (N1), the second terminal of the third switch (SW3) is coupled to a third reference voltage terminal (VREF3), and the control terminal of the third switch (SW3) is configured to receive a third control signal (VCTRL3);
a voltage level at the second reference voltage terminal (VREF2) is lower than a voltage level at the third reference voltage terminal (VREF3);
during the transition period (PT), the second switch (SW2) is turned on according to the second control signal (VCTRL2), and the third switch (SW3) is turned off according to the third control signal (VCTRL3), such that a voltage provided by the second reference voltage terminal (VREF2) is received at the first node (N1); and
during the steady period (PS), the second switch (SW2) is turned off according to the second control signal (VCTRL2), and the third switch (SW3) is turned on according to the third control signal (VCTRL3) such that a voltage provided by the third reference voltage terminal (VREF3) is received at the first node (N1).

12. The amplifier (100, 200, 500, 600, 800, 900) of claim 1, **characterised in that**:
during the transition period (PT), a current flowing through the first transistor (T1) is substantially unstable; and
during the steady period (PS), the current flowing through the first transistor (T1) is substantially stable.

13. An operation method (1100) for an amplifier (100, 200, 500, 600, 800, 900), **characterised in that**:
the amplifier (100, 200, 500, 600, 800, 900) comprises:
a signal input terminal (NIN) configured to receive an input signal (SIN);
a signal output terminal (NOUT) configured to output an amplified signal (SOUT);
an amplification circuit (101, 201, 501, 601, 801, 901) coupled between the signal input terminal (NIN) and the signal output terminal (NOUT), the amplification circuit (101, 201, 501, 601, 801, 901) comprising a first transistor (T1), and the first transistor (T1) comprising a first terminal, a second terminal, a control terminal, and a body terminal, wherein the first terminal of the first transistor (T1) is coupled to a first node (N1), the second terminal of the first transistor (T1) is coupled to a second node (N2), the control terminal of the first transistor (T1) is coupled to the signal input terminal (NIN), and the body terminal of the first transistor (T1) is floating; and
at least one variable voltage generation circuit (110, 210, 520, 620, 830, 930) coupled to the amplification circuit (101, 201, 501, 601, 801, 901); and
the operation method (1100) comprises:
during a transition period (PT), the at least one variable voltage generation circuit (110, 210, 520, 620, 830, 930) providing a first voltage difference (VDS1) between the second terminal and the first terminal of the first transistor (T1) (Step 1110); and
during a steady period (PS), the at least one variable voltage generation circuit (110, 210, 520, 620, 830, 930) providing a second voltage difference (VDS2) between the second terminal and the first terminal of the first transistor (T1) (Step 1120);
wherein the first voltage difference (VDS1) is greater than the second voltage difference (VDS2).

14. The operation method (1100) of claim 13, **characterised in that**:
the amplification circuit (201, 501, 601, 801, 901) further comprises:
a second transistor (T2) comprising a first terminal, a second terminal, and a control terminal, wherein the first terminal of the second transistor (T2) is coupled to the second node (N2), the second terminal of the second transistor (T2) is coupled to the signal output terminal (NOUT), and the control terminal of the second transistor (T2) is coupled to a third node (N3); and
the at least one variable voltage generation circuit (110, 210, 520, 620, 830, 930) comprises a first variable voltage generation circuit (210) coupled to the third node (N3) and a second variable voltage generation circuit (520, 620) coupled to the second node (N2);
the method (1100) further comprises:
the first variable voltage generation circuit (210) providing a first pulse voltage signal (VPS1) at the third node (N3); and
the second variable voltage generation circuit (520, 620) providing a second pulse voltage signal (VPS2) at the second node (N2);
wherein:
during the transition period (PT), the first pulse voltage signal (VPS1) has a first voltage level (L1), the second pulse voltage signal (VPS2) has a third voltage level (L3); and
during the steady period (PS), the first pulse voltage signal (VPS1) has a second voltage level (L2), the second pulse voltage signal (VPS2) has a fourth voltage level (L4).

15. The operation method (1100) of claim 13, **characterised in that**:
the at least one variable voltage generation circuit (110, 210, 520, 620, 830, 930) comprises a third variable voltage generation circuit (830, 930) coupled to the first node (N1); and
the method (1100) further comprises:
the third variable voltage generation circuit (830, 930) providing a third pulse voltage signal (VPS3) at the first node (N1);
wherein:
during the transition period (PT), the third pulse voltage signal (VPS3) has a fifth voltage level (L5); and
during the steady period (PS), the third pulse voltage signal (VPS3) has a sixth voltage level (L6).
